(19) Europäisches Patentamt
European Patent Office
Office européen des brevets

(11) EP 2 899 510 A1

(12) **EUROPÄISCHE PATENTANMELDUNG**

(43) Veröffentlichungstag:
**29.07.2015 Patentblatt 2015/31**

(51) Int Cl.:
*G01D 5/14* (2006.01)        *G01R 33/07* (2006.01)
*G01R 33/09* (2006.01)

(21) Anmeldenummer: **15000557.7**

(22) Anmeldetag: **22.11.2013**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(30) Priorität: **14.01.2013 DE 102013000431**

(62) Dokumentnummer(n) der früheren Anmeldung(en) nach Art. 76 EPÜ:
**13005477.8 / 2 767 804**

(71) Anmelder: **Micronas GmbH**
**79108 Freiburg (DE)**

(72) Erfinder:
• **Ritter, Joachim**
**79540 Lörrach (DE)**
• **Franke, Jörg**
**79117 Freiburg (DE)**

(74) Vertreter: **Koch Müller**
**Patentanwaltsgesellschaft mbH**
**Maaßstraße 32/1**
**69123 Heidelberg (DE)**

Bemerkungen:
Diese Anmeldung ist am 26-02-2015 als Teilanmeldung zu der unter INID-Code 62 erwähnten Anmeldung eingereicht worden.

(54) **Schaltung und Messsystem**

(57) Messsystem, mit einer Magnetfeldsensoranordnung (10), die einen ersten Magnetfeldsensor (11) zur Messung einer ersten Komponente ($B_x$) eines Magnetfeldes (B) in einer ersten Raumrichtung (x) und einen zweiten Magnetfeldsensor (12) zur Messung einer zweiten Komponente ($B_z$) des Magnetfeldes ($\underline{B}$) in einer zweiten Raumrichtung (z) aufweist, mit einem Geber (31, 34), der ausgebildet ist eine erste Magnetfeldänderung mit einer ersten Periodizität ($T_1$) in der Magnetfeldsensoranordnung (10) erzeugen, und mit einer Auswertungsschaltung (20), an die der erste Magnetfeldsensor (11) und der zweite Magnetfeldsensor (12) angeschlossen sind, wobei die Auswertungsschaltung (20) eingerichtet ist, zur Erzeugung eines ersten Signals (D) mit der ersten Periodizität ($T_1$) aus einem ersten Messsignal (A) des ersten Magnetfeldsensors (11) und einem zweiten Messsignal (B) des zweiten Magnetfeldsensors (12) entsprechend einer Arcustangens-Funktion (arctan (A/B)), wobei der Geber (31, 34) ausgebildet ist, eine zweite Magnetfeldänderung mit einer zweiten Periodizität (T2) in der Magnetfeldsensoranordnung (10) zu erzeugen, und wobei die Auswertungsschaltung (20) eingerichtet ist, ein zweites Signal (C) mit der zweiten Periodizität (T2) aus dem ersten Messsignal (A) des ersten Magnetfeldsensors (11) und dem zweiten Messsignal (B) des zweiten Magnetfeldsensors (12) entsprechend einer Betragsfunktion (|A| + |B|) zu erzeugen.

Fig. 2

EP 2 899 510 A1

**Beschreibung**

Die vorliegende Erfindung betrifft eine Schaltung und ein Messsystem.

Aus der EP 2 354 769 A1 sind ein Winkelgeber und ein Verfahren zur Bestimmung eines Winkels zwischen einer Sensoranordnung und einem Magnetfeld bekannt. Der Winkelgeber weist einen das Magnetfeld erzeugenden, bezüglich einer Drehachse in unterschiedliche Drehlagen relativ zu der Sensoranordnung verstellbaren Magneten auf. Die Sensoranordnung weist einen ersten Magnetfeldsensor zur Erfassung einer quer zur Drehachse orientierten ersten Magnetfeldkomponente und einen zweiten Magnetfeldsensor zur Erfassung einer zweiten Magnetfeldkomponente auf, die quer zu einer von der Drehachse und der ersten Magnetfeldkomponente aufgespannten Ebene angeordnet ist. Die Sensoranordnung weist einen dritten Magnetfeldsensor zur Erfassung einer in Richtung der Drehachse orientierten dritten Magnetfeldkomponente auf.

Aus der DE 10 2008 059 401 A1 ist ein Halbleiterchip und ein Verfahren zum Erzeugen von Impulsflanken bekannt, die der Bewegung eines mechanischen Teils synchron zugeordnet sind. Ein Magnetfeld wird erzeugt und mindestens zwei Messsignale werden für das Magnetfeld erfasst. Das Magnetfeld wird derart in Abhängigkeit von der Bewegung des mechanischen Teils verändert, dass die Messsignale zueinander phasenverschoben moduliert werden. Ein erstes Messsignal wird mit einem ersten Referenzwert verglichen. Ein zweites Messsignal wird mit einem zweiten Referenzwert verglichen. Der Betrag des ersten Messsignals wird mit dem Betrag des zweiten Messsignals verglichen. Eine Impulsflanke wird erzeugt, wenn mindestens einer dieser Vergleiche eine Übereinstimmung ergibt oder das Ergebnis des betreffenden Vergleichs sein Vorzeichen ändert.

Aus der EP 1 111 392 A1 ist ein Erfassen der Drehzahl und Winkelstellung eines rotierenden Rades mit anpassbarer Schaltschwelle zur Driftkompensation bekannt. Das Erfassen der Drehzahl und der Winkelstellung eines Rades erfolgt mittels eines berührungslos das Rad abtastenden Sensors, der eine Impulsfolge erzeugt. Die Amplitude der Impulse wird in einem Vergleicher mit einer variablen Schaltschwelle verglichen. Die Schaltschwelle wird so angepasst, dass der Betrag der Differenz zwischen den Amplituden der Impulse und der Schaltschwelle einen vorgebbaren Höchstwert nicht überschreitet.

Aus ELEKTRONIK PRAXIS, Nr. 18, 17. Sept. 2008, Seite 22, J. Quasdorf ist ein optisches Nonius-System bekannt. Die Interpolation analoger Sinussignale ist eine Auswertefunktion bei Positionssensoren. Mit einem speziellen Verfahren ist es möglich, mehrere Messskalen auszuwerten und zu einem Positionswert zu kombinieren. Damit sind Messsysteme möglich, die eine hohe integrale Genauigkeit oder sehr hohe Auflösungen mit guter differenzieller Genauigkeit bieten. Für die Abtastung genügt ein kleiner optischer Sensor.

Aus der EP 1 503 182 B1 ist ein Drehwinkelsensor bekannt, wie dieser in der Fig. 1 dargestellt ist. Der Drehwinkelsensor weist eine drehbare Welle, einen mit der drehbaren Welle gekoppelten Magneten und ein magnetempfindliches Sensorelement auf. Das Sensorelement erzeugt in Abhängigkeit vom relativen Drehwinkel zwischen dem Magneten und dem Sensor ein sinusförmiges und ein kosinusförmiges Ausgangssignal. Der Drehwinkelsensor weist eine Auswerteeinheit auf, die aus den Ausgangssignalen ein dem Drehwinkel entsprechendes Signal erzeugt. Die Welle ist längs einer Führungsbahn bei ihrer Drehung um ihre Achse zusätzlich linear parallel zu ihrer Achse verschieblich geführt, so dass sich der Abstand zwischen Magnet und Sensor entsprechend einer Steigung der Führungsbahn verändert. Die Auswerteeinheit ermittelt aus Ausgangssignalen des Sensorelementes ein Signal, aus welchem der Abstand zwischen dem Sensorelement und dem Magneten und damit die Anzahl der vollen Umdrehungen der Welle ermittelbar sind. Aus den sinusförmigen und kosinusförmigen Ausgangssignalen wird ein Feinsignal innerhalb einer vollen Umdrehung ermittelt und dieses Feinsignal wird zu dem Wert der vollen Umdrehung multipliziert mit 360° hinzuaddiert.

Vor diesem Hintergrund ist es die Aufgabe der vorliegenden Erfindung, ein Messsystem anzugeben, das den Stand der Technik weiterbildet.

Diese Aufgabe wird durch ein Messsystem mit den Merkmalen des unabhängigen Anspruchs 1 gelöst. Vorteilhafte Weiterbildungen sind Gegenstand von abhängigen Ansprüchen und in der Beschreibung enthalten.

Demzufolge ist ein Messsystem mit einer Magnetfeldsensoranordnung und mit einem rotatorisch beweglichen Geber und mit einer Auswertungsschaltung vorgesehen.

Die Magnetfeldsensoranordnung weist einen in einem Halbleiterchip integrierten ersten Magnetfeldsensor zur Messung einer ersten Komponente eines Magnetfeldes in einer ersten Raumrichtung und einen im Halbleiterchip integrierten zweiten Magnetfeldsensor zur Messung einer zweiten Komponente des Magnetfeldes in einer zweiten Raumrichtung auf.

Der rotatorisch bewegliche Geber weist eine Mehrzahl von Magneten auf, die mit jeder Umdrehung des Gebers mittels einer Mehrzahl von Polpaaren eine drehwinkelabhängige erste Magnetfeldänderung mit einer ersten Periodizität in der Magnetfeldsensoranordnung erzeugen.

An die Auswertungsschaltung sind der erste Magnetfeldsensor und der zweite Magnetfeldsensor angeschlossen.

Die Auswertungsschaltung Ist eingerichtet, zur Erzeugung eines ersten Signals mit der ersten Periodizität aus einem ersten Messsignal des ersten Magnetfeldsensors und einem zweiten Messsignal des zweiten Magnetfeldsensors entsprechend einer Arcustangens-Funktion.

Der rotatorische Geber ist ausgebildet, eine drehwinkelabhängige zweite Magnetfeldänderung mit einer zweiten Periodizität in der Magnetfeldsensoranordnung zu erzeugen. Eine Periode der zweiten Periodizität entspricht einer Umdrehung des Gebers.

Die Auswertungsschaltung ist eingerichtet, ein zweites Signal mit der zweiten Periodizität aus dem ersten Messsignal des ersten Magnetfeldsensors und dem zweiten Messsignal des zweiten Magnetfeldsensors entsprechend einer Betragsfunktion zu erzeugen.

Die Auswertungsschaltung weist eine Logik auf, die eingerichtet ist, einen Drehwinkel des Gebers basierend auf dem ersten Signal und dem zweiten Signal zu bestimmen.

Die Aufgabe wird weiterhin durch ein Messsystem mit den Merkmalen des unabhängigen Anspruchs 2 gelöst. Vorteilhafte Weiterbildungen sind Gegenstand von abhängigen Ansprüchen und in der Beschreibung enthalten.

Demzufolge ist ein Messsystem mit einer Magnetfeldsensoranordnung und mit einem entlang einer Bahn beweglichen Geber und mit einer Auswertungsschaltung vorgesehen.

Die Magnetfeldsensoranordnung weist einen in einem Halbeiterchip integrierten ersten Magnetfeldsensor zur Messung einer ersten Komponente eines Magnetfeldes in einer ersten Raumrichtung und einen im Halbeiterchip integrierten zweiten Magnetfeldsensor zur Messung einer zweiten Komponente des Magnetfeldes in einer zweiten Raumrichtung auf.

Der entlang der Bahn bewegliche Geber weist eine Mehrzahl von Magneten aufweist, die mit einer Bewegung des Gebers entlang der Bahn mittels einer Mehrzahl von Polpaaren eine wegabhängige erste Magnetfeldänderung mit einer ersten Periodizität in der Magnetfeldsensoranordnung erzeugen.

An die Auswertungsschaltung sind der erste Magnetfeldsensor und der zweite Magnetfeldsensor angeschlossen.

Die Auswertungsschaltung ist eingerichtet, zur Erzeugung eines ersten Signals mit der ersten Periodizität aus einem ersten Messsignal des ersten Magnetfeldsensors und einem zweiten Messsignal des zweiten Magnetfeldsensors entsprechend einer Arcustangens-Funktion.

Der Geber ist ausgebildet, eine wegabhängige zweite Magnetfeldänderung mit einer zweiten Periodizität in der Magnetfeldsensoranordnung zu erzeugen. Die zweite Periodizität ist größer als die erste Periodizität.

Die Auswertungsschaltung ist eingerichtet, ein zweites Signal mit der zweiten Periodizität aus dem ersten Messsignal des ersten Magnetfeldsensors und dem zweiten Messsignal des zweiten Magnetfeldsensors entsprechend einer Betragsfunktion zu erzeugen.

Die Auswertungsschaltung weist eine Logik auf, die eingerichtet ist, eine Position des Gebers basierend auf dem ersten Signal und dem zweiten Signal zu bestimmen.

Die Aufgabe wird weiterhin durch ein Messsystem mit den Merkmalen des unabhängigen Anspruchs 3 gelöst. Vorteilhafte Weiterbildungen sind Gegenstand von abhängigen Ansprüchen und in der Beschreibung enthalten.

Demzufolge ist ein Messsystem mit einer Magnetfeldsensoranordnung und mit einem rotatorisch beweglichen Geber und mit einer Auswertungsschaltung vorgesehen.

Die Magnetfeldsensoranordnung weist einen in einem Halbeiterchip integrierten ersten Magnetfeldsensor zur Messung einer ersten Komponente eines Magnetfeldes in einer ersten Raumrichtung und einen im Halbeiterchip integrierten zweiten Magnetfeldsensor zur Messung einer zweiten Komponente des Magnetfeldes in einer zweiten Raumrichtung und einen Magneten auf.

Der rotatorisch bewegliche Geber weist eine Mehrzahl von Zähnen auf. Ein Material der Zähne beeinflusst das Magnetfeld des Magneten.

Die Zähne des Gebers sind ausgebildet, mit jeder Umdrehung des Gebers eine drehwinkelabhängige erste Magnetfeldänderung mit einer ersten Periodizität In der Magnetfeldsensoranordnung zu erzeugen.

An die Auswertungsschaltung sind der erste Magnetfeldsensor und der zweite Magnetfeldsensor angeschlossen.

Die Auswertungsschaltung ist eingerichtet, zur Erzeugung eines ersten Signals mit der ersten Periodizität aus einem ersten Messsignal des ersten Magnetfeldsensors und einem zweiten Messsignal des zweiten Magnetfeldsensors entsprechend einer Arcustangens-Funktion.

Der Geber ist ausgebildet, eine drehwinkelabhängige zweite Magnetfeldänderung mit einer zweiten Periodizität in der Magnetfeldsensoranordnung zu erzeugen. Eine Periode der zweiten Periodizität entspricht einer Umdrehung des Gebers.

Die Auswertungsschaltung ist eingerichtet, ein zweites Signal mit der zweiten Periodizität aus dem ersten Messsignal des ersten Magnetfeldsensors und dem zweiten Messsignal des zweiten Magnetfeldsensors entsprechend einer Betragsfunktion zu erzeugen.

Die Auswertungsschaltung weist eine Logik auf, die eingerichtet ist, einen Drehwinkel des Gebers basierend auf dem ersten Signal und dem zweiten Signal zu bestimmen.

Die Aufgabe wird weiterhin durch ein Messsystem mit den Merkmalen des unabhängigen Anspruchs 4 gelöst.

Vorteilhafte Weiterbildungen sind Gegenstand von abhängigen Ansprüchen und in der Beschreibung enthalten.

Demzufolge ist ein Messsystem mit einer Magnetfeldsensoranordnung und mit einem entlang einer Bahn beweglichen Geber und mit einer Auswertungsschaltung vorgesehen.

Die Magnetfeldsensoranordnung weist einen in einem Halbeiterchip integrierten ersten Magnetfeldsensor zur Messung einer ersten Komponente eines Magnetfeldes in einer ersten Raumrichtung und einen im Halbeiterchip integrierten zweiten Magnetfeldsensor zur Messung einer zweiten Komponente des Magnetfeldes in einer zweiten Raumrichtung und einen Magneten auf.

Der entlang der Bahn bewegliche Geber weist eine Mehrzahl von Zähnen auf. Ein Material der Zähne beeinflusst das Magnetfeld des Magneten.

Die Zähne des Gebers sind ausgebildet, bei einer Bewegung des Gebers entlang der Bahn eine wegabhängige erste Änderung des Magnetfelds mit einer ersten Periodizität in der Magnetfeldsensoranordnung zu erzeugen.

An die Auswertungsschaltung sind der erste Magnetfeldsensor und der zweite Magnetfeldsensor angeschlossen.

Die Auswertungsschaltung ist eingerichtet, zur Erzeugung eines ersten Signals mit der ersten Periodizität aus einem ersten Messsignal des ersten Magnetfeldsensors und einem zweiten Messsignal des zweiten Magnetfeldsensors entsprechend einer Arcustangens-Funktion.

Der Geber ist ausgebildet, eine wegabhängige zweite Änderung des Magnetfelds mit einer zweiten Periodizität in der Magnetfeldsensoranordnung zu erzeugen. Die zweite Periodizität ist größer als die erste Periodizität.

Die Auswertungsschaltung ist eingerichtet, ein zweites Signal mit der zweiten Periodizität aus dem ersten Messsignal des ersten Magnetfeldsensors und dem zweiten Messsignal des zweiten Magnetfeldsensors entsprechend einer Betragsfunktion zu erzeugen.

Die Auswertungsschaltung weist eine Logik auf, die eingerichtet ist, eine Position des Gebers basierend auf dem ersten Signal und dem zweiten Signal zu bestimmen.

Durch die zuvor erläuterten Lösungen der Aufgabe durch die Merkmale des Ansprüche 1 bis 4 wird eine Vielzahl von Vorteilen erzielt. Durch die Mehrzahl der Magneten des Gebers, bzw. durch die Mehrzahl der Zähne des Gebers kann eine hohe Auflösung der Position erzielt werden. In Synergie kann zudem die Position innerhalb der Umdrehung des Gebers aus den gleichen Messsignalen eindeutig gewonnen werden. Ein zusätzlicher Sensor ist nicht erforderlich.

Gemäß einer vorteilhaften Ausgestaltung lautet die Arkustangens-Funktion:

$$D = \arctan (A/B) \tag{1}$$

D ist das erste Signal, A ist das erste Messsignal und B ist das zweite Messsignal.

Gemäß einer vorteilhaften Ausgestaltung lautet die Betrags-Funktion:

$$C = |A| + |B| \tag{2}$$

C ist das zweite Signal, A ist das erste Messsignal und B ist das zweite Messsignal. Alternativ können auch eine andere Arkustangens-Funktion oder eine andere Betrags-Funktion vorgesehen sein.

In einer vorteilhaften Ausgestaltung ist vorgesehen, dass eine Periode der zweiten Periodizität einer Wegstrecke zwischen Endpunkten der Bahn entspricht. Beispielsweise ändert sich das zweite Signal proportional zur zurückgelegten Strecke zwischen den beiden Endpunkten.

Gemäß einer vorteilhaften Weiterbildung ist der Geber ausgebildet, die zweite Magnetfeldänderung mittels einer Änderung einer Luftspaltbreite zwischen dem Geber und der Magnetfeldsensoranordnung zu erzeugen. Alternativ kann vorgesehen sein, dass zumindest ein Magnet des Gebers eine von den deren Magneten abweichende Magnetisierung aufweist.

In einer anderen vorteilhaften Weiterbildung ist die Logik eingerichtet, ein Ergebnis der Betragsfunktion mit einer Anzahl von Schwellwerten zu vergleichen. Wird das Ergebnis der Betragsfunktion beispielsweise mit einem einzigen Schwellwert verglichen, kann eine Nullstellung des Gebers ermittelt werden. Eine größere Anzahl von Schwellwerten, wie diese beispielsweise in einem Analog-Digital-Umsetzer mit mehreren Bits verwendet wird, ermöglicht eine Positionsbereichsbestimmung des Gebers. Die Positionsbereichsbestimmung weist dabei vorzugsweise eine gröbere Auflösung als das erste Signal auf.

Die zuvor beschriebenen Weiterbildungsvarianten sind sowohl einzeln als auch in Kombination besonders vorteilhaft. Dabei können sämtliche Weiterbildungsvarianten untereinander kombiniert werden. Einige mögliche Kombinationen sind in der Beschreibung der Ausführungsbeispiele der Figuren erläutert. Diese dort dargestellten Möglichkeiten von Kombinationen der Weiterbildungsvarianten sind jedoch nicht abschließend.

Im Folgenden wird die Erfindung durch Ausführungsbeispiele anhand zeichnerischer Darstellungen näher erläutert.

Dabei zeigen

Fig. 1 ein Messsystem nach dem Stand der Technik,

Fig. 2 eine schematische Ansicht eines Ausführungsbeispiels eines Messsystems,

Fig. 3 eine schematische Ansicht eines weiteren Ausführungsbeispiels eines Messsystems,

Fig. 4 eine schematische Ansicht eines weiteren Ausführungsbeispiels eines Messsystems,

Fig. 5 eine schematische Ansicht eines weiteren Ausführungsbeispiels eines Messsystems,

Fig. 6 eine schematische Ansicht eines weiteren Ausführungsbeispiels eines Messsystems,

Fig. 7 ein schematisches Diagramm mit Messsignalen eines weiteren Ausführungsbeispiels eines Messsystems,

Fig. 8 ein schematisches Diagramm eines Verlaufs eines Magnetfeldvektors eines weiteren Ausführungsbeispiels eines Messsystems,

Fig. 9 ein schematisches Diagramm eines Verlaufs eines Magnetfeldvektors eines weiteren Ausführungsbeispiels eines Messsystems,

Fig. 10 ein schematischer Blockschaltplan eines weiteren Ausführungsbeispiels eines Messsystems, und

Fig. 11 ein schematisches Diagramm mit Messsignalen eines weiteren Ausführungsbeispiels eines Messsystems.

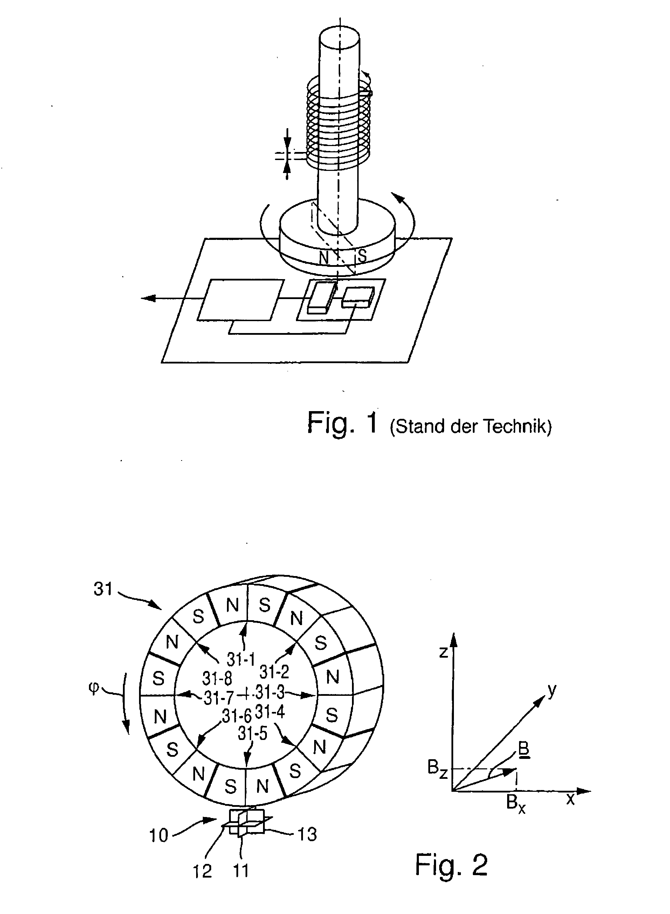

In Fig. 2 ist ein Messsystem schematisch dargestellt. Das Messsystem weist eine Magnetfeldsensoranordnung 10 auf. In der Magnetfeldsensoranordnung 10 wird ein Magnetfeldvektor $\underline{B}$ bestimmt. Der Magnetfeldvektor $\underline{B}$ ist in Fig. 2 in einem Koordinatensystem mit den Raumrichtungen x, y und z schematisch dargestellt. Für eine einfachere Erfassbarkeit der Darstellung ist der Ursprung des Koordinatensystems von der Mitte der Magnetfeldsensoranordnung 10 versetzt dargestellt. Ebenfalls sind im Koordinatensystem Komponenten $B_x$, $B_z$ des Magnetfeldvektor $\underline{B}$ dargestellt.

Die Magnetfeldsensoranordnung 10 weist einen in einem Halbeiterchip integrierten ersten Magnetfeldsensor 11 zur Messung einer ersten Komponente $B_x$ des Magnetfeldvektors $\underline{B}$ des Magnetfeldes in einer ersten Raumrichtung x auf. Die Magnetfeldsensoranordnung 10 weist einen im Halbeiterchip integrierten zweiten Magnetfeldsensor 12 zur Messung einer zweiten Komponente $B_z$ des Magnetfeldvektors $\underline{B}$ des Magnetfeldes in einer zweiten Raumrichtung z auf. Zudem weist die Magnetfeldsensoranordnung 10 einen im Halbeiterchip integrierten dritten Magnetfeldsensor 13 zur Messung einer dritten Komponente By des Magnetfeldvektors $\underline{B}$ des Magnetfeldes in einer dritten Raumrichtung y auf.

Das Messsystem der Fig. 2 weist einen rotatorisch beweglichen Geber 31 in Form eines Polrades auf. Das Polrad 31 weist eine Anzahl von Magneten aufweist, die mit jeder Umdrehung des Polrades 31 mittels einer Mehrzahl von Polpaaren 31-1, 31-2, 31-3, 31-4, 31-5, 31-6, 31-7, 31-8 eine drehwinkelabhängige erste Magnetfeldänderung mit einer ersten Periodizität T1 in der Magnetfeldsensoranordnung 10 erzeugen. Das Polrad 31 als rotatorischer Geber 31 ist mit acht Polpaaren 31-1, 31-2, 31-3, 31-4, 31-5, 31-6, 31-7, 31-8 ausgebildet, eine drehwinkelabhängige zweite Magnetfeldänderung mit einer zweiten Periodizität T2 in der Magnetfeldsensoranordnung 10 zu erzeugen. Eine Periode der zweiten Periodizität T2 entspricht einer Umdrehung des Polrades 31. Somit wiederholt sich die zweite Magnetfeldänderung bei jeder Umdrehung des Polrades 31. Dabei erzeugen die Polpaare 31-1, 31-2, 31-3, 31-4, 31-5, 31-6, 31-7, 31-8 in der Magnetfeldsensoranordnung 10 den Magnetfeldvektor B mit unterschiedlichen Längen. Die zweite Magnetfeldänderung ist somit im Ausführungsbeispiel der Fig. 2 eine Magnetfeld-Amplituden-Modulation, die die erste Magnetfeldänderung überlagert. Mit der zweiten Magnetfeldänderung steigt beispielsweise die Länge des Magnetfeldvektors B vom ersten Polpaar 31-1 bis zum letzten Polpaar 31-8 in einer Drehrichtung stetig an. In diesem Fall weist die Amplitudenmodulation zur zweiten Magnetfeldänderung eine Sägezahnform auf.

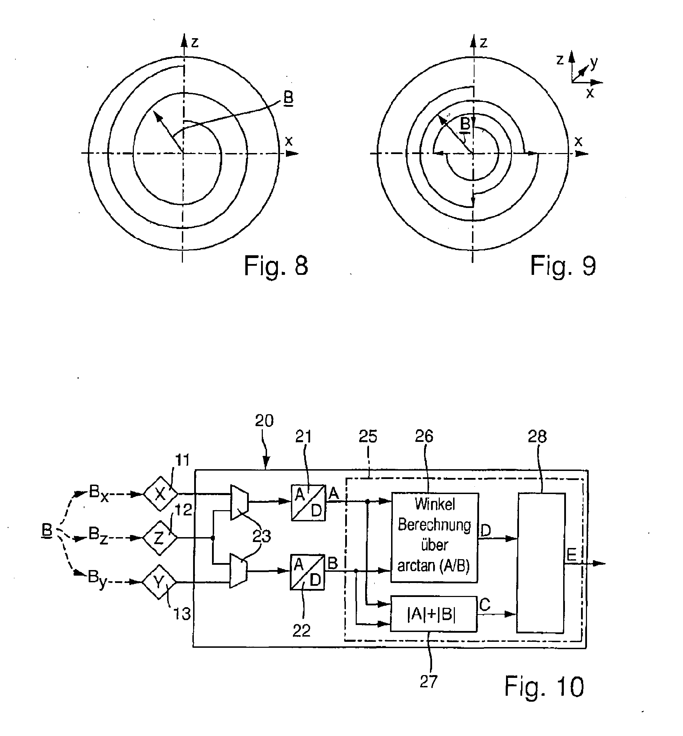

In Fig. 10 ist eine Auswertungsschaltung 20 des Messsystems gezeigt. An die Auswertungsschaltung 20 sind der erste Magnetfeldsensor 11 und der zweite Magnetfeldsensor 12 und der dritte Magnetfeldsensor 13 angeschlossen. Die Auswertungsschaltung 20 weist einen ersten Analog-Digital-Umsetzer 21 und einen zweiten Analog-Digital-Umsetzer 22 auf. Mittels der Multiplexer 23 können die analogen Ausgangssignale der Magnetfeldsensoren 11, 12, 13 auf die Eingänge der Analog-Digital-Umsetzer 21, 22 geschaltet werden. Je nach Lage der Auswertungsschaltung 20 können so die für die Messaufgabe benötigten Magnetfeldsensoren 11, 12, 13 ausgewählt werden. Alternativ zum Ausführungsbeispiel der Fig. 10 kann für jeden Magnetfeldsensor 11, 12, 13 ein Analog-Digital-Umsetzer vorgesehen sein. In diesem Fall würden auf der digitalen Seite die Signale ausgewählt werden und die Multiplexer 23 könnten entfallen. Alternativ könnte auch ein einziger schneller Analog-Digital-Umsetzer verwendet werden, und die Analogsignale der Magnetfeldsensoren 11, 12, 13 werden in schneller Folge zyklisch auf den Eingang des einzigen Analog-Digital-Umsetzers mittels eines Multiplexers geschaltet.

Im Folgenden soll für das Ausführungsbeispiel der Fig. 10 angenommen werden, dass der erste Magnetfeldsensor 11 auf den ersten Analog-Digital-Umsetzer 21 und der zweite Magnetfeldsensor 12 auf den zweiten Analog-Digital-Umsetzer 22 geschaltet sind.

Die Auswertungsschaltung 20 weist eine Logik 25 auf, wobei in Fig. 10 mehrere Funktionsblöcke 26, 27, 28 der Logik 25 schematisch dargestellt sind. Die Funktionsblöcke 26, 27, 28 sind beispielsweise durch Software oder spezielle Hardware realisiert. Die Auswertungsschaltung 20 ist mittels des Funktionsblocks 26 zur Erzeugung eines ersten Signals D mit der ersten Periodizität aus einem ersten Messsignal A des ersten Magnetfeldsensors 11 und einem zweiten Messsignal B des zweiten Magnetfeldsensors 12 entsprechend einer Arcustangens-Funktion eingerichtet:

$$D = \arctan(A/B) \qquad\qquad (1)$$

Die Auswertungsschaltung 20 ist mittels des Funktionsblocks 27 zur Erzeugung eines zweiten Signals C mit der zweiten Periodizität aus dem ersten Messsignal A des ersten Magnetfeldsensors 11 und dem zweiten Messsignal B des zweiten Magnetfeldsensors 12 entsprechend einer Betragsfunktion eingerichtet:

$$C = |A| + |B| \qquad\qquad (2)$$

Die Logik 25 ist mittels des Funktionsblocks 28 eingerichtet, einen Drehwinkel $\varphi$ des Polrades 31 basierend auf dem ersten Signal D und dem zweiten Signal C zu bestimmen.

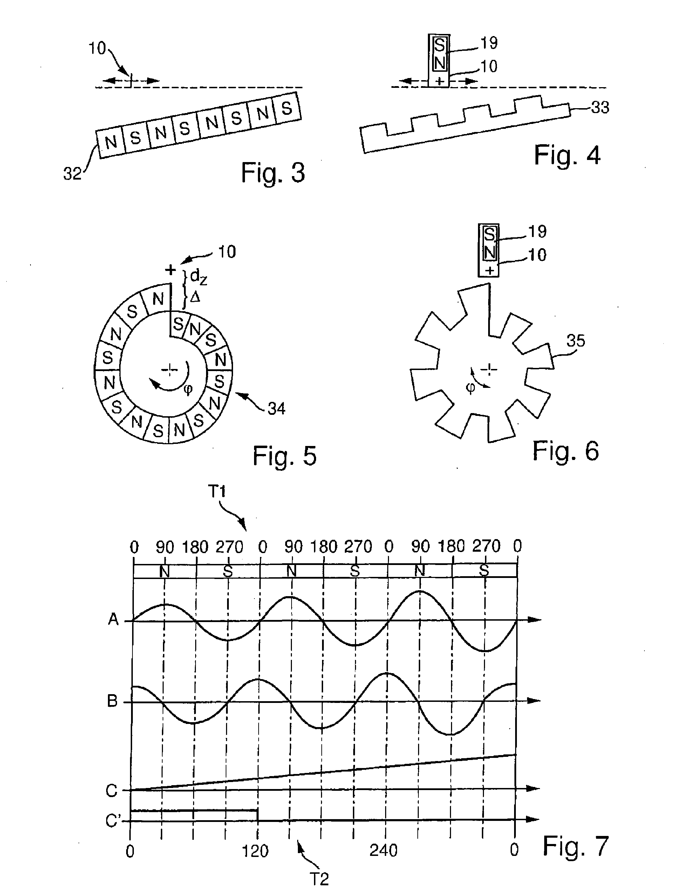

Ein Verlauf der Signale A, B und C ist in Fig. 7 für ein anderes Ausführungsbeispiels mit drei Polpaaren schematisch dargestellt. Das erste Messsignal A ist gegenüber dem zweiten Messsignal B um 90° phasenverschoben (Sinus und Kosinus). Das zweite durch die Betragsfunktion gewonnene Signal C weist eine Sägezahnform auf. Im Ausführungsbeispiel der Fig. 7 ist die Periode der zweiten Periodizität T2 dreimal so groß wie die Periode der ersten Periodizität T1. Die Arcustangensfunktion stellt die Grundfrequenz (Polpaar) dar. Die Betragsfunktion erlaubt das Unterscheiden mehrerer Polpaare untereinander.

In Fig. 7 ist ein weiteres Ausführungsbeispiel schematisch dargestellt, indem keine Sägezahnsignalform, sondern eine Amplitudenerhöhung für genau ein Polpaar nach Art einer Rechteckfunktion gemäß dem Signal C' erzeugt wird. Das Polpaar mit der Amplitudenerhöhung kann als Nullstelle ausgewertet werden, wobei die anderen Drehwinkel durch Zählen der Polpaare nach der Nullstelle ermittelt werden. Diese Ausführungsform ist aufgrund des Digitalcharakters der Rechteckform besonders robust gegenüber Störungen, lässt eine genaue Drehwinkelbestimmung erst nach Passieren der Nullstelle zu.

Die Ausführungsbeispiele der Figuren 3, 4, 5 und 6 zeigen unterschiedliche Messsysteme, die ebenfalls eine Änderung der Länge des Magnetfeldvektors B̲ bewirken.

Im Ausführungsbeispiel der Fig. 3 führt die Magnetfeldsensoranordnung 10 entlang der gestrichelten Linie eine Relativbewegung zum Geber 32 aus. Der Geber 32 weist wiederum eine Mehrzahl von Polpaaren auf. Demzufolge ist der Geber 32 einer geraden Bahn beweglich. Die Magnete des Gebers 32 erzeugen mit einer Bewegung des Gebers 32 entlang der Bahn mittels der Polpaare eine wegabhängige erste Magnetfeldänderung mit einer ersten Periodizität in der Magnetfeldsensoranordnung 10. Dabei sind die Magnete des Gebers 32 derart angeordnet, dass in Abhängigkeit von der Position des Gebers 32 ein Abstand zwischen den Magneten des Gebers 32 und der Magnetfeldsensoranordnung 10 zur Erzeugung der zweiten Periodizität verändert wird. Dabei nimmt mit Verringerung des Abstands die Länge des Magnetfeldvektors zu.

Im Ausführungsbeispiel der Fig. 4 weist der Geber 33 eine Mehrzahl von Zähnen auf. Die Zähne beeinflussen ein Magnetfeld in einer Magnetfeldsensoranordnung 10. Die Magnetfeldsensoranordnung 10 weist hierzu einen Magneten 19 auf. Der Geber 33 ist entlang einer Bahn relativ zur Magnetfeldsensoranordnung 10 beweglich, so dass die Magnetfeldsensoranordnung 10 eine Relativbewegung entlang der gestrichelten Linie ausführt. Die Zähne des Gebers 33 sind ausgebildet, bei einer Bewegung des Gebers 33 entlang der Bahn eine wegabhängige erste Änderung des Magnetfelds mit einer ersten Periodizität in der Magnetfeldsensoranordnung 10 zu erzeugen. Dabei sind die Zähne des Gebers 35 derart angeordnet, dass in Abhängigkeit von der Bewegung des Gebers 33 ein Abstand zwischen den Spitzen der Zähne des Gebers 33 und der Magnetfeldsensoranordnung 10 zur Erzeugung einer zweiten Periodizität verändert wird. Dabei nimmt mit Verringerung des Abstands die Länge des Magnetfeldvektors zu.

Im Ausführungsbeispiel der Fig. 5 ist der Geber 34 ein Polrad 34. Das Polrad 34 weist eine Mehrzahl von Magneten zur Bildung von Polpaaren auf. Die Magnete des Gebers 34 erzeugen mit einer Rotation des Gebers 34 mittels der Polpaare eine wegabhängige erste Magnetfeldänderung mit einer ersten Periodizität in der Magnetfeldsensoranordnung 10. Dabei sind die Magnete des Gebers 34 derart angeordnet, dass in Abhängigkeit vom Drehwinkel $\varphi$ des Gebers 34 ein Abstand zwischen den Magneten des Gebers 34 und der Magnetfeldsensoranordnung 10 verändert wird. Dabei nimmt mit Verringerung des Abstands die Länge des Magnetfeldvektors zu.

Im Ausführungsbeispiel der Fig. 6 ist der Geber 35 ein Zahnrad 35 mit einer Mehrzahl von Zähnen. Die Zähne beeinflussen ein Magnetfeld in einer Magnetfeldsensoranordnung 10. Die Magnetfeldsensoranordnung 10 weist hierzu einen Magneten 19 auf. Der Geber 35 ist rotatorische beweglich. Dabei sind die Zähne des Gebers 35 derart ausgebildet, dass in Abhängigkeit vom Drehwinkel $\varphi$ des Gebers 35 ein Abstand zwischen den Spitzen der Zähne des Gebers 35 und der Magnetfeldsensoranordnung 10 zur Erzeugung der zweiten Periodizität verändert wird. Dabei nimmt mit Verringerung des Abstands die Länge des Magnetfeldvektors zu.

In den Ausführungsbeispielen der Figuren 3 bis 6 ist eine Relativbewegung zwischen Geber 35 und Magnetfeldsensoranordnung 10 möglich. Dabei kann die Magnetfeldsensoranordnung 10 ortfest sein und der Geber 35 bewegt werden. Ebenfalls ist es möglich, den Geber 35 ortsfest anzuordnen und die Magnetfeldsensoranordnung 10 zu bewegen. Auch ist es möglich, sowohl Geber 35 als auch die Magnetfeldsensoranordnung 10 zu bewegen.

Ein weiteres Ausführungsbeispiel ist in Fig. 8 schematisch dargestellt. Fig. 8 zeigt einen Magnetfeldvektor B̲, sowie dessen Verlauf in Abhängigkeit von einer Bewegung eines Gebers eines Messsystems. Jede mechanische Umdrehung erzeugt einen im Urzeigersinn zunehmenden Betrag der Magnetfeldstärke, welcher aus einem sinusförmigen Magnetfeld durch zwei um 90° versetzten Magnetfeldsensoren für ein Sinusmesssignal und ein Kosinusmesssignal erfasst und berechnet wird. Die magnetische Amplitude nimmt im Uhrzeigesinn zu, so dass mehrere magnetische Polpaare innerhalb einer Umdrehung und über beide Umdrehungen hinweg Polpaare voneinander unterschieden werden können. In dieser Darstellung entspricht die Länge des Pfeils B̲ dem Betrag und die Richtung dem Winkel des Magnetfeldes.

Mit nur zwei Raumrichtungen x, y - ohne Modulation in die weitere Raumrichtung z - können mehrere Umdrehungen oder mehrere geradlinig aufeinander folgende Polpaare sicher unterschieden werden, solange keine Kreuzung der durch den Verlauf des Magnetvektors B̲ beschriebenen Linie stattfindet. In der Fig. 9 ist ein Ausführungsbeispiel mit einer derartigen Kreuzung der durch den Verlauf des Magnetvektors B̲ beschriebenen Linie dargestellt. Kontinuierliche Rotation lässt beim Kreuzen Mehrdeutigkeiten entstehen. eine Instanz, welche die Historie kennt, kann diese Mehrdeutigkeiten auslösen. Der Betrag kann gemäß Fig. 8 sich kontinuierlich ändern was zu einer Spiralform führt. Ändert sich der Betrag gemäß Fig. 9 sprunghaft, führt dies zu einer gestuften Spiralform. In den beiden Ausführungsbeispielen der Figuren 8 und 9 können zumindest zwei Polpaare innerhalb jeder Umdrehung unterschieden werden.

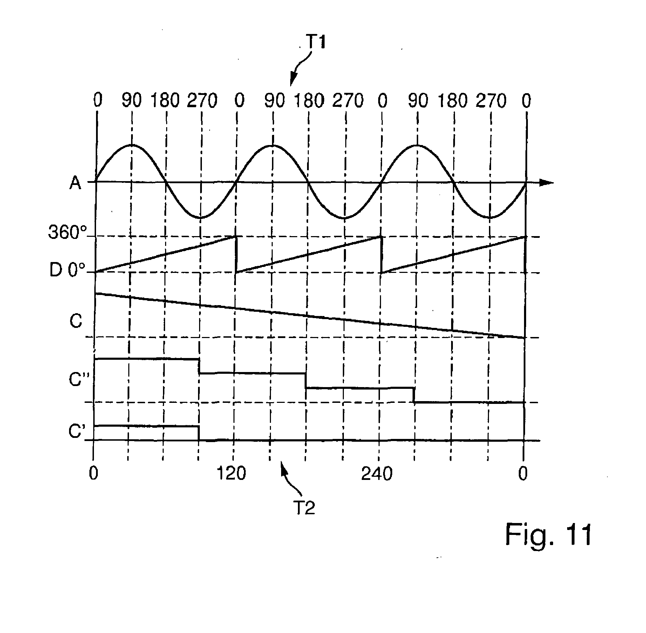

Fig. 11 zeigt ein Ausführungsbeispiel mit drei Polpaaren in Form eines Diagramms. Die Signale beziehen sich dabei auf die Fig. 10. Zuoberst ist ein durch die Polpaare erzeugtes Sinussignal A dargestellt. Unterhalb ist das Signal D des Ausgangswertes der Arcustangens-Funktion dargestellt. Das Betragssignal C ist als fallendes Sägenzahnsignal gebildet. Zusätzlich zeigt Fig. 11 ein Signal C" einer Betragsfunktion, wobei sich der Betrag stufenförmig in vier Stufen ändert. Zusätzlich kann mittels eines Vergleichers eine Nullstellung anhand des Signals C' erfolgen.

Die Erfindung ist nicht auf die dargestellten Ausgestaltungsvarianten der Figuren 2 bis 11 beschränkt. Beispielsweise ist es möglich, andere Betragsfunktionen zu verwenden. Auch ist es möglich, andere Geber mit einer komplexeren Anordnung von Magneten vorzusehen. Die Funktionalität des Messsystems gemäß den Figuren 2 und 10 kann besonders vorteilhaft für ein Verstellsystem oder Antriebssystem verwendet werden.

Bezugszeichenliste

| | |
|---|---|
| 10 | Magnetfeldsensoranordnung |
| 11, 12, 13 | Magnetfeldsensor |
| 19 | Magnet |
| 20 | Auswertungsschaltung |
| 21, 22 | Analog-Digital-Umsetzer |
| 23 | Multiplexer |
| 25 | Logik |
| 26, 27, 28 | Funktionsblock der Logik |
| 31, 32, 33, 34, 35 | Geber |
| 31-1, 31-2, 31-3, 31-4, 31-5, 31-6, 31-7, 31-8 | Polpaar |

| φ | Drehwinkel |
|---|---|
| B | Magnetfeldvektor |
| $B_x$, $B_z$ | Magnetfeldkomponente |
| A, B, C, C', C", D | Signal |
| x, y, z | Raumrichtung |
| T1, T2 | Periodizität |

**Patentansprüche**

1. Messsystem,
   mit einer Magnetfeldsensoranordnung (10), die einen in einem Halbeiterchip integrierten ersten Magnetfeldsensor (11) zur Messung einer ersten Komponente ($B_x$) eines Magnetfeldes (B) in einer ersten Raumrichtung (x) und einen im Halbeiterchip integrierten zweiten Magnetfeldsensor (12) zur Messung einer zweiten Komponente ($B_z$) des Magnetfeldes (B) in einer zweiten Raumrichtung (z) und einen Magneten (19) aufweist,
   mit einem rotatorisch beweglichen Geber (35), der eine Mehrzahl von Zähnen aufweist,
   wobei ein Material der Zähne das Magnetfeld (B) des Magneten (19) beeinflusst,
   wobei die Zähne des Gebers (35) ausgebildet sind, mit jeder Umdrehung des Gebers (35) eine drehwinkelabhängige erste Magnetfeldänderung mit einer ersten Periodizität ($T_1$) in der Magnetfeldsensoranordnung (10) zu erzeugen, und
   mit einer Auswertungsschaltung (20), an die der erste Magnetfeldsensor (11) und der zweite Magnetfeldsensor (12) angeschlossen sind,
   wobei die Auswertungsschaltung (20) eingerichtet ist, zur Erzeugung eines ersten Signals (D) mit der ersten Periodizität ($T_1$) aus einem ersten Messsignal (A) des ersten Magnetfeldsensors (11) und einem zweiten Messsignal (B) des zweiten Magnetfeldsensors (12) entsprechend einer Arcustangens-Funktion (arctan (A/B)),
   **dadurch gekennzeichnet,**

   - **dass** der Geber (35) ausgebildet ist, eine drehwinkelabhängige zweite Magnetfeldänderung mit einer zweiten Periodizität ($T_2$) in der Magnetfeldsensoranordnung (10) zu erzeugen, wobei eine Periode der zweiten Periodizität ($T_2$) einer Umdrehung des Gebers (35) entspricht,
   - **dass** die Auswertungsschaltung (20) eingerichtet ist, ein zweites Signal (C) mit der zweiten Periodizität ($T_2$) aus dem ersten Messsignal (A) des ersten Magnetfeldsensors (11) und dem zweiten Messsignal (B) des zweiten Magnetfeldsensors (12) entsprechend einer Betragsfunktion (|A|+|B|) zu erzeugen, und
   - **dass** die Auswertungsschaltung (20) eine Logik (25) aufweist, die eingerichtet ist, einen Drehwinkel (φ) des Gebers (35) basierend auf dem ersten Signal (D) und dem zweiten Signal (C) zu bestimmen.

2. Messsystem nach einem der vorhergehenden Ansprüche,
   **dadurch gekennzeichnet,**

   - **dass** der Geber (32, 33, 34, 35) ausgebildet ist, die zweite Magnetfeldänderung mittels einer Änderung einer Luftspaltbreite zwischen dem Geber (32, 33, 34, 35) und der Magnetfeldsensoranordnung (10) zu erzeugen.

3. Messsystem nach einem der vorhergehenden Ansprüche,
   **dadurch gekennzeichnet,**

   - **dass** die Logik (25) eingerichtet ist, ein Ergebnis der Betragsfunktion (|A|+|B|) mit einer Anzahl von Schwellwerten zu vergleichen.

Fig. 1 (Stand der Technik)

Fig. 2

Fig. 3

Fig. 4

Fig. 5

Fig. 6

Fig. 7

Fig. 8

Fig. 9

Fig. 10

Fig. 11

Europäisches
Patentamt

European
Patent Office

Office européen
des brevets

**EUROPÄISCHER RECHERCHENBERICHT**

**Nummer der Anmeldung**

EP 15 00 0557

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 10 2010 019508 A1 (KOSTAL LEOPOLD GMBH & CO KG [DE]) 10. November 2011 (2011-11-10) | 1,3 | INV. G01D5/14 |
| Y | * Absatz [0001] * <br> * Absatz [0015] - Absatz [0019] * <br> * Absatz [0024] - Absatz [0027] * <br> * Absatz [0031] - Absatz [0036] * <br> * Abbildungen 1,2,5,9 * <br> ----- | 2 | ADD. G01R33/07 G01R33/09 |
| X | US 2012/095712 A1 (KOMASAKI YOSUKE [JP] ET AL) 19. April 2012 (2012-04-19) * Absatz [0011] - Absatz [0015] * <br> * Absatz [0061] - Absatz [0074] * <br> * Absatz [0135] - Absatz [0142] * <br> * Absatz [0184] - Absatz [0199] * <br> * Abbildungen 1-5,14-15,23-28 * <br> ----- | 1 | |
| Y | EP 1 477 772 A1 (TYCO ELECTRONICS AMP GMBH [DE]) 17. November 2004 (2004-11-17) | 2 | |
| A | * Absatz [0014] - Absatz [0019] * <br> * Abbildungen 1,2 * <br> ----- | 1 | RECHERCHIERTE SACHGEBIETE (IPC) |
| A | WO 2011/095179 A1 (SKF AB [SE]; MOL HENDRIK ANNE [NL]) 11. August 2011 (2011-08-11) * Seite 8, Zeile 8 - Seite 10, Zeile 30 * <br> * Seite 19, Zeile 13 - Seite 24, Zeile 31 * <br> * Abbildungen 1-17 * <br> ----- | 1 | G01D G01R |

Der vorliegende Recherchenbericht wurde für alle Patentansprüche erstellt

| Recherchenort | Abschlußdatum der Recherche | Prüfer |
|---|---|---|
| München | 28. Mai 2015 | Paraf, Edouard |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
................................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 15 00 0557

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

28-05-2015

| Im Recherchenbericht angeführtes Patentdokument | Datum der Veröffentlichung | Mitglied(er) der Patentfamilie | Datum der Veröffentlichung |
|---|---|---|---|
| DE 102010019508 A1 | 10-11-2011 | KEINE | |
| US 2012095712 A1 | 19-04-2012 | CN 102445221 A<br>DE 102011083249 A1<br>JP 5177197 B2<br>JP 2012083257 A<br>US 2012095712 A1 | 09-05-2012<br>19-04-2012<br>03-04-2013<br>26-04-2012<br>19-04-2012 |
| EP 1477772 A1 | 17-11-2004 | KEINE | |
| WO 2011095179 A1 | 11-08-2011 | CN 102822631 A<br>EP 2531819 A1<br>US 2013307530 A1<br>WO 2011095179 A1 | 12-12-2012<br>12-12-2012<br>21-11-2013<br>11-08-2011 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2354769 A1
- DE 102008059401 A1
- EP 1111392 A1
- EP 1503182 B1

**In der Beschreibung aufgeführte Nicht-Patentliteratur**

- **J. QUASDORF.** *ELEKTRONIK PRAXIS,* 17. September 2008, 22